# EUROPÄISCHE PATENTSCHRIFT

(11) **EP 1 012 100 B1**
(45) Veröffentlichungstag und Bekanntmachung des Hinweises auf die Patenterteilung: **22.05.2002**
(21) Anmeldenummer: 98955338.3
(22) Anmeldetag: 21.09.1998
(51) Int. Cl.: B65H 59/12

(54) **DRAHTBREMSE**
WIRE BRAKE
FREIN POUR FIL

(30) Priorität: 20.09.1997 DE 19748014
(43) Veröffentlichungstag der Anmeldung: 28.06.2000
(73) Patentinhaber: Hesse & Knipps GmbH, 33100 Paderborn (DE)
(72) Erfinder: WALTHER, Frank, D-33034 Brakel (DE)
(74) Vertreter: Hudler, Frank, Dipl.-Ing.
(86) Internationale Anmeldenummer: DE9802793
(87) Internationale Veröffentlichungsnummer: WO9915452

(56) Entgegenhaltungen:
- EP-A- 0 330 053
- EP-A- 0 498 936
- DE-C- 19 633 256
- US-A- 2 595 270
- US-A- 4 559 886

## Beschreibung

Die Erfindung betrifft eine Drahtbremse für Wedge-Bondautomaten mit einer hinter dem zugehörigen Bondwerkzeug (Wedge) angeordneten und längs des Bonddrahtes bewegbaren Drahtzange zum Äblösen eines Bonddrahtes von der geöffneten Drahtzange.

Bei derartigen Wedge-Bondautomaten dient die Drahtzange zum Vorschub des Bonddrahtes unter das Bondwerkzeug, oder zum Festhalten des Bonddrahtes nach der Fertigstellung einer Drahtbrücke, d.h. des zweiten Bondkontaktes zum Zwecke des Abreißens des Bonddrahtes vom zweiten Bondkontakt. Ein Beispiel für einen solchen Bondautomat geht aus der DE 35 19 594 A1, oder auch der DE 43 37 837 A1, hervor. In beiden Fällen muß der Bonddraht durch die Drahtzange mit einer vorgegebenen Kraft geklemmt werden. Wird die Drahtzange anschließend geöffnet, so haftet der Bonddraht an einer der Zangenbacken lose an. Würde nun aber der Wedge-Bondautomat ungeachtet dieser nicht zu vermeidenden Tatsache weiterarbeiten, so würde der Bondprozeß negativ beeinflußt. Beispielsweise müßte dann mit ungleichmäßigen Drahtbrücken oder ungleichmäßigen Taillängen oder auch Fehlbondungen gerechnet werden.

Um diese negative Beeinflussung des Bondprozesses zu vermeiden, ist es allgemein üblich, den Bonddraht durch zwei Filzplättchen zu führen, die als Drahtbremse wirken. Mit derarti gen Drahtbremsen wird eine ausreichende Kraft erzeugt, die den Bonddraht sicher von der Drahtzange ablöst. Allerdings treten bei einem längeren Betrieb Probleme dadurch auf, daß sich der Filz aufbauscht und einzelne lose Fasern den Bonddraht verschmutzen. Darüberhinaus sammeln sich am Bonddraht anhaftende Verunreinigungen im Filz an und werden gleichmäßig auf den Bonddraht verteilt.

Eine andere Variante der Realisierung einer Drahtbremse besteht darin, den Bonddraht in einem Teflonschlauch bis zur Drahtzange zu führen. Dabei wird der Umstand ausgenutzt, daß die Haftkraft zwischen Bonddraht und Teflonschlauch größer ist, als zwischen Bonddraht und einer der geöffneten Backen der Drahtzange. Mit einer Verschmutzung des Bonddrahtes durch den Teflonschlauch ist zwar kaum zu rechnen, jedoch ist als besonderer Nachteil dieser Variante die undefinierte Bremskraft zu sehen. Das ist insbesondere bei schnellen Bewegungen des Bonddrahtes im Teflonschlauch der Fall.

Eine andere Bremsvorrichtung ist aus der US-A-2 595 270 bekannt geworden. Insbesondere wird hier eine Fadenbremse für Garn beschrieben, bei der der Faden durch eine Reihe von Stiften geführt wird. Diese Stifte sind auf einer Basis befestigt und stehen aus dieser wechselweise mit einem Öffnungswinkel von 10° v-förmig hervor. Damit wir der durch die Stifte hindurchgeführte Faden wechselweise seitlich ausgelenkt, so daß eine Bremskraft auf diesen ausgeübt wird. Die Größe der seitlichen Auslenkung wird größer, je tiefer der Faden in die Stifte eintaucht.

Ausgenutzt wird hier die Tatsache, daß bei zunehmender Umschlingung der Stifte gleichzeitig eine Zunahme der auf den Faden ausgeübten Bremskraft zu verzeichnen ist.

Eine derartige Lösung läßt sich jedoch nicht auf eine Bremse für einen Bonddraht übertragen, da der Bonddraht bei der Zuführung zum Wedge auf keine Weise mechanisch bleibend verformt werden darf. Diese Gefahr besteht bei der Lösung nach der US-A-2 595 270, wobei gleichzeitig unzulässige Reibungskräfte auf den Bonddraht ausgeübt werden.

Der Erfindung liegt deshalb die Aufgabe zugrunde, eine Drahtbremse zu schaffen, bei der die Nachteile des Standes der Technik vermieden werden und mit der es möglich ist, die erforderliche Bremskraft zu variieren.

Die der Erfindung zugrundeliegende Aufgabenstellung wird bei einer Drahtbremse der eingangs genannten Art dadurch gelöst, daß die Dahtbremse Führungselemente aufweist, die aus mehreren an den Bonddraht anlegbaren Umlenkungen bestehen und zwei Ebenen aufweist, zwischen denen der Bonddraht zur Erzeugung einer Bremskraft mit einem vorgegebenen Betrag im elastischen Bereich seitlich auslenkbar ist, indem eine mittlere den Bonddraht auslenkende Umlenkung vorgesehen ist, die zwischen den zwei Ebenen zur Führung des Bonddrahtes hervorsteht und quer zur Längserstreckung des Bonddrahtes verschiebbar ist, wobei der Bonddraht durch die mittlere Umlenkung von den Ebenen abgehoben wird.

Durch die Erzeugung einer Biegekraft auf den Bonddraht läßt sich die erforderliche Bremskraft genau definiert vorgeben. Insbesondere ist hier von Vorteil, daß die vorgegebene Bremskraft unabhängig von der Geschwindigkeit ist, mit der sich der Bonddraht durch die Drahtbremse bewegt. Das bedeutet, daß eine negative Beeinflussung der Bondparameter nicht zu verzeichnen ist.

In einer bevorzugten Fortbildung der Erfindung ist die Größe der seitlichen Auslenkung einstellbar.

In einer weiteren Ausgestaltung der Erfindung ist gegenüber der mittleren Umlenkung eine erste und eine zweite Umlenkung vorgesehen, die im Abstand zueinander positioniert sind, wobei der Bonddraht an die erste und zweite Umlenkung anlegbar ist.

Um zu verhindern, daß die Führungsflächen selbst einen Einfluß auf die Bremskraft ausüben, weisen die Führungsflächen der Umlenkungen auf denen der Bonddraht entlanggleitet, jeweils eine leicht gewölbte bzw. ballige Oberfläche auf.

In einer bevorzugten Ausführungsform sind die Führungsflächen der Umlenkungen poliert.

Weiterhin ist von Vorteil, wenn die erste und die zweite Umlenkung in der Weise ausgerichtet sind, daß die jeweilige Flächennormale senkrecht zum Bonddraht verläuft. Außerdem sollte der Bonddraht im Ein- und Auslauf der Drahtbremse tangential an die Ebenen angelegt werden. Diese Maßnahmen gewährleisten eine geringstmögliche durch die Drahtbremse verursachte Reibungskraft, so daß die Größe der Bremskraft hauptsächlich durch die Biegekraft bestimmt wird.

Die Erfindung soll nachfolgend an einem Ausführungsbeispiel näher erläutert werden. In der zugehörigen Zeichnung ist eine erfindungsgemäße Drahtbremse 1 schematisch dargestellt. Diese Drahtbremse 1 besteht aus zwei Ebenen 6, 7, zwischen denen ein Zwischenraum 9 freigehalten ist und auf denen der Bonddraht 2 entlanggleitet.

Um die erforderliche Bremskraft für den Bonddraht 2 zu erzeugen, wird dieser mit Hilfe einer Umlenkung 3, die im Zwischenraum 9 quer zur Längsrichtung des Bonddrahtes 2 verschiebbar ist, seitlich ausgelenkt. Die seitliche Verschiebung der Umlenkung 3 kann manuell, z.B. mit einer Stellschraube, oder auch mit einem Voice-Coil-Antrieb o.dgl. erfolgen.

Damit der Bonddraht zu einem gleichmäßigen Bogen im elastischen Bereich ausgelenkt wird, sind etwa gegenüber den Ebenen 6, 7 weitere Umlenkungen 3, 5 vorgesehen, die jedoch fest positioniert sein können. Die Umlenkungen 3, 5 sind in der Weise ausgerichtet, daß die jeweilige Flächennormale 8 senkrecht zum Bonddraht 2 verläuft. Damit wird gewährleistet, daß der Bonddraht 2 nicht unter Umständen über eine Kante gezogen wird, was zu einer bleibenden Verformung führen würde. Bei einer solchen Verformung müßte mit Fehlbondungen gerechnet werden, da ein verformter Bonddraht 2 nicht mehr ordnungsgemäß unter dem Wedge positioniert werden könnte. Außerdem wird durch die Umlenkungen 3, 5 erreicht, daß der Bonddraht 2 tangential an die Ebenen 6, 7 angelegt wird. Diese Maßnahmen gewährleisten eine geringstmögliche durch die Drahtbremse verursachte Reibungskraft, so daß die Größe der Bremskraft hauptsächlich durch die Biegekraft bestimmt wird.

Mit Hilfe der Umlenkung 4 wird der Bonddraht so weit seitlich ausgelenkt, daß dieser die Führungsflächen an den Umlenkungen 3, 5 berührt. Die Größe der Auslenkung des Bonddrahtes 2 bestimmt nun die Größe der Bremskraft, die entsprechend der Stellung der mittleren Umlenkung 4 variiert werden kann.

Um jegliche Oberflächeneinflüsse der Fuhrungsflächen auf den Umlenkungen 3, 4, 5 zu vermeiden, sind diese leicht gewölbt, bzw. ballig ausgeführt und zusätzlich poliert.

### Bezugszeichenliste

- 1: Drahtbremse
- 2: Bonddraht
- 3: Umlenkung
- 4: mittlere Umlenkung
- 5: Umlenkung
- 6: Ebene
- 7: Ebene
- 8: Flächennormale
- 9: Zwischenraum

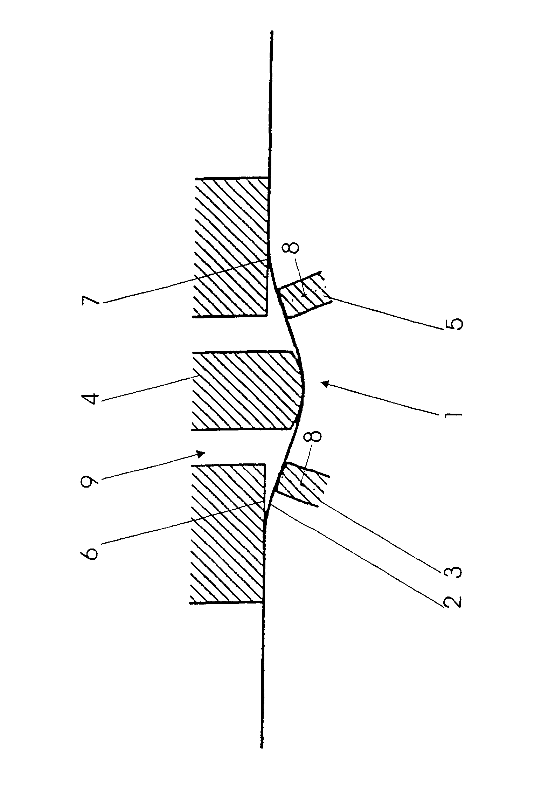

## Patentansprüche

1. Drahtbremse für Wedge-Bondautomaten mit einer hinter dem zugehörigen Bondwerkzeug (Wedge) angeordneten und längs des Bonddrahtes bewegbaren Drahtzange zum Ablösen eines Bonddrahtes von der geöffneten Drahtzange, **dadurch gekennzeichnet, daß** die Drahtbremse (1) Führungselemente aufweist, die aus mehreren an den Bonddraht (2) anlegbaren Umlenkungen (3, 4, 5) bestehen und zwei Ebenen (6, 7) aufweist, zwischen denen der Bonddraht (2) zur Erzeugung einer Bremskraft mit einem vorgegebenen Betrag im elastischen Bereich seitlich auslenkbar ist, indem eine mittlere den Bonddraht (2) auslenkende Umlenkung (4) vorgesehen ist, die zwischen den zwei Ebenen (6, 7) zur Führung des Bonddrahtes (2) hervorsteht und quer zur Längserstreckung des Bonddrahtes (2) verschiebbar ist, wobei der Bonddraht (2) durch die mittlere Umlenkung (4) von den Ebenen (6, 7) abgehoben wird.

2. Drahtbremse nach Anspruch 1 und 2, **dadurch gekennzeichnet, daß** die Größe der seitlichen Auslenkung des Bonddrahtes (2) einstellbar ist.

3. Drahtbremse nach Anspruch 1 und 2, **dadurch gekennzeichnet, daß** gegenüber der mittleren Umlenkung (4) eine erste und eine zweite Umlenkung (3, 5) vorgesehen ist, die im Abstand zueinander positioniert sind und daß der Bonddraht (2) an die erste und zweite Umlenkung (3, 5) anlegbar ist.

4. Drahtbremse nach den Ansprüchen 1 bis 3, **dadurch gekennzeichnet, daß** die Führungsflächen der Umlenkungen (3, 4, 5) auf denen der Bonddraht (2) entlanggleitet, jeweils eine leicht gewölbte bzw. ballige Oberfläche aufweisen.

5. Drahtbremse nach Anspruch 4, **dadurch gekennzeichnet, daß** die Führungsflächen der Umlenkungen (3, 4, 5) poliert sind.

6. Drahtbremse nach einem der Ansprüche 1 bis 5, **dadurch gekennzeichnet, daß** die erste und die zweite Umlenkung (3, 5) in der Weise ausgerichtet ist, daß die jeweilige Flächennormale (8) senkrecht zum Bonddraht (2) verläuft.

7. Drahtbremse nach den Ansprüchen 1 bis 6, **dadurch gekennzeichnet, daß** der Bonddraht (2) im Einund Auslauf der Drahtbremse (1) tangential an die Ebenen (6, 7) angelegt wird.

## Claims

1. Wire brake for automatic wedge bonding machines comprising a wire plier arranged behind the associated bonding tool (wedge) and movable along the bonding wire for detaching the bonding wire from the open plier, **characterized in that** the wire brake is provided with guiding elements having a plurality of deflectors (3, 4, 5) applicable with the bonding wire (2) defining two planes (6, 7) between those the bonding wire (2) is deflectable within the elastic range, to generate a braking force with a predetermined amount by a central deflector (4) deflecting the bonding wire (2) projecting between the two planes (6, 7) for guiding the bonding wire (2) and which is displaceable transverse to the longitudinal extension of the bonding wire (2), wherein the bonding wire (2) is liftened from the planes (6, 7) by the central deflector (4).

2. Wire brake according to Claim 1, **characterized in that** the magnitude of lateral deflection of the bonding wire (2) is adjustable.

3. Wire brake according to Claim 1 and 2, **characterized in that** opposite to the middle deflector (4) is provided a first and a second deflector (3, 5) which are positioned in a spaced-apart relationship and that the bonding wire (2) contactable with the first and the second deflector (3, 5).

4. Wire brake according to claims 1 to 3, **characterized in that** the deflectors (3, 4, 5) have guide surfaces at which the bonding wire (2) slides along, each surfaces are provided with a slight arched or a spherical surface.

5. Wire brake according to claim 4, **characterized in that** guide surfaces of the deflectors (3, 4, 5) are polished.

6. Wire brake according to each of the claims 1 to 5, **characterized in that** the first and the second deflector (3, 5) are aligned such that a respective normal of the surface (8) is substantially perpendicular to the bonding wire (2).

7. Wire brake according to each of the claims 1 to 6, **characterized in that** the bonding wire (2) at the outlet and the inlet is applied tangentially to the planes (6, 7).

## Revendications

1. Frein à câble pour liaison à cale automatique avec un coupe-fil mobile placé derrière l'outil de liaison (cale) et le long du câble de liaison pour séparer un câble de liaison du coupe-fil ouvert **caractérisé par le fait que** le frein à câble (1) présente des éléments de conduite qui comprennent plusieurs coudes (3,4,5) pouvant être posés au câble de liaison (2) et présente deux niveaux (6,7) entre lesquels le câble de liaison (2) peut être guidé latéralement pour produire une force de freinage avec d'importance déterminée dans le champ élastique, dans lequel un coude médian (4) pouvant être dévié est prévu dépassant entre les deux niveaux (6,7) pour le guidage du câble de liaison et qui est réglable transversalement à l'avancée longitudinale du câble de liaison (2) tout en soulevant le câble de liaison (2) à travers le coude médian (4) des niveaux (6,7).

2. Le frein à câble selon la spécification 1 et 2 est **caractérisé par le fait que** la dimension de la déviation latérale du câble de liaison (2) est réglable.

3. Le frein à câble selon la spécification 1 et 2 est **caractérisé par le fait que** par rapport à la déviation médiane (4) un premier et un second coude (3-5) sont prévus positionnés à distance l'un de l'autre et que le câble de liaison (2) peut être posé au premier et au deuxième coude.

4. Le frein à câble selon les spécifications 1 à 3 est **caractérisé par le fait que** les surfaces de guidage des coudes (3,4,5) le long desquels le câble de liaison glisse présentent une surface respectivement légèrement cintrée ou bombée.

5. Le frein à câble selon la spécification 4 est **caractérisé par le fait que** les surfaces de guidage des coudes (3,4,5,) sont polies.

6. Le frein à câble selon l'une des spécification 1 à 5, est **caractérisé par le fait que** le 1^{er} et le dernier coude (3,5) sont dirigés de telle sorte que les normes des surfaces (8) ont un tracé perpendiculaire au câble de liaison (2).

7. Le frein à câble selon les spécifications 1 à 6 est **caractérisé par le fait que** le câble de liaison (2) est posé à l'entrée et à la sortie du frein à câble (1), tangentiellement aux niveaux (6,7).
